## Europäisches Patentamt
## European Patent Office
## Office européen des brevets

⑱

(11) Publication number: **0 124 708**
**B1**

(12) # EUROPEAN PATENT SPECIFICATION

(45) Date of publication of patent specification: **24.05.89**

(21) Application number: **84102364.1**

(22) Date of filing: **05.03.84**

(51) Int. Cl.⁴: **H 01 L 39/24**

(54) **A process for the manufacture of intrinsically multifilament A-15 superconductors and superconductors obtained with such process.**

(30) Priority: **07.04.83 IT 6737883**

(43) Date of publication of application:
**14.11.84 Bulletin 84/46**

(45) Publication of the grant of the patent:
**24.05.89 Bulletin 89/21**

(84) Designated Contracting States:
**AT BE CH DE FR GB LI NL SE**

(56) References cited:
**FR-A-2 265 159**
**GB-A-2 050 878**
**GB-A-2 092 043**
**US-A-3 465 430**
**US-A-4 489 219**

(73) Proprietor: **EUROPA METALLI - LMI S.p.A.**
**Borgo Pinti, 97/99**
**I-50121 Firenze (IT)**

(73) Proprietor: **E.N.E.A., COMITATO NAZIONALE**
**PER LA RICERCA E LO SVILUPPO DELL'ENERGIA**
**NUCLEARE E DELLE ENERGIE ALTERNATIVE**
**Regina Margherita, 125**
**I-00198 Roma (Viale) (IT)**

(72) Inventor: **Ceresara, Sergio**
**Via Buonamici, 15**
**I-55100 Lucca (IT)**
Inventor: **Sacchetti, Nicola**
**Via Ottavio Mamiglio, 7**
**I-00044 Frascati (Roma) (IT)**

(74) Representative: **Bongiovanni, Guido et al**
**c/o Ingg. Carlo e Mario Torta Via Viotti 9**
**I-10121 Torino (IT)**

Courier Press, Leamington Spa, England.

## Description

The present invention relates to a process for the production of multifilamentary superconducting conductors of the A-15 type in which the superconductor material is a compound of the chemical formula $A_3B$ (where A=Nb, V or their alloys: and B=Al, Sn, Ge, Ga, Si or their alloys) embedded in a matrix of copper for stabilisation. The present invention further relates to a superconducting conductor produced with this method.

As is known, the commercially available superconducting materials can be divided into two groups: Nb-Ti alloys (ductile) for application in magnetic fields up to 9T, and intermetallic A-15 compounds (fragile) for magnetic fields greater than 9T. The Nb-Ti multifilamentary superconductors are obtained by assembling together a plurality of monofilaments each of which is constituted by an Nb-Ti superconducting element embedded in a copper matrix. The whole composition of monofilaments thus obtained is inserted into a further copper matrix (for example constituted by a hollow copper container) and the thus obtained composite is transformed by plastic working (for example by drawing) until its transverse section has been reduced to the required dimensions therefore obtaining, because of the contraction consequent on the elongation of the blank, a wirelike conductor.

In the case of A-15 superconductors the plastic working of the compound $A_3B$ is not possible; on the contrary, this superconductor compound can be obtained only by means of an interdiffusion process between A and B caused by the heat treatment of the finished conductor, which conductor, in the three best known manufacturing processes, can be constituted respectively by: i) a bronze matrix rich in the element B (that is to say copper alloy—B) containing filaments of the element A, in the case of the "bronze route" process; ii) a matrix of copper containing filaments constituted by a mixture of the elements A and B finally sub-divided, in the case of the "powder metallurgy" process; iii) a matrix of copper containing filaments constituted by intimately connected elements A and B, in the case of the "thin sheet metallurgy" process.

Whatever the process selected, the manufacture of A-15 multifilamentary strip conductors always requires the formation of monofilaments. Manufacturing monofilaments is laborious and expensive in that it is divided into a series of operations which are difficult to automate such as: drawing of the hexagonal monofilament, cutting the hexagons to length, degreasing, pickling, rinsing, drying and assembling.

Moreover, monofilaments made with the described method can become damaged and/or broken during the drawing operations, interrupting the continuity of the filaments and leading to a reduction in the useful section of the cable for the passage of current.

The object of the present invention is that of providing a process for obtaining multifilamentary superconductors of the A-15 type stabilised with copper, free from the disadvantages described above, which can be quickly and economically performed and automated simply.

The said object is achieved by the present invention as claimed in Claim 1 in that it relates to a process for obtaining multi-filamentary superconductors of the A-15 type, comprising a plurality of filaments constituted by a superconductor material of the general chemical formula $A_3B$ embedded in a copper matrix, comprising:

— preparation of a composite sheet which can be wound in a spiral and comprising two sheets of material A with a plurality of strips (4) of material B sandwiched between them, the strips being located alongside one another, spaced with a predetermined separation and extending transversely between the longer sides of the sheets;

— connecting the three layer composite sheet A/B/A to a sheet of copper (Cu) and obtaining an A/B/A/Cu multi-layer sheet;

— preparation of a coil by winding the said multilayer sheet A/B/A/Cu around a cylindrical copper element with a sheet of the material A disposed in contact with the surface of this latter;

— mounting the said coil within a copper container in such a way as to obtain a blank, and working the blank by plastic deformation thereof to obtain a conductor of predetermined dimensions and having transverse dimensions less than that of the blank and a length greater than the blank;

— twisting the said conductor with a predetermined pitch;

— heating the said conductor in an inert environment to a temperature lying within a range of values such as to avoid the formation of liquid phase but sufficient to cause an interdiffusion between the materials A and B to obtain the compound $A_3B$.

The process according to the present invention serves to form a multifilamentary superconductor of the A-15 type stabilised with copper as claimed in Claim 7.

For a better understanding of the present invention there will now be given a non limitative description of an embodiment, with reference to the attached drawings, in which:

Figures 1 and 2 illustrate two different elements obtained at the end of different respective phases of the process according to the present invention; and

Figure 3 illustrates a phase in the process of the invention.

The superconductor material of the type A-15 is constituted by an intermetallic compound of the general chemical formula $A_3B$ where A represents niobium (Nb) or vanadium (V) or an alloy containing one of these elements, and where B represents aluminium (Al), tin (Sn), germanium (Ge), gallium (Ga) or silicon (Si) or an alloy containing one or more of the elements. Like all intermetallic compounds, the compound $A_3B$ has great fragility, whilst both the metals A and the metals B, with the exception of Ge and Si, have a satisfactory workability.

Such a cable is obtained, according to the invention, by means of a series of simple operations or successive phases, all easily automatable, which will now be described in detail.

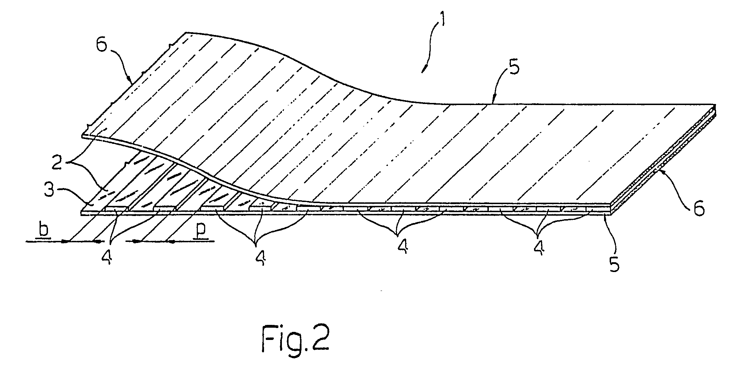

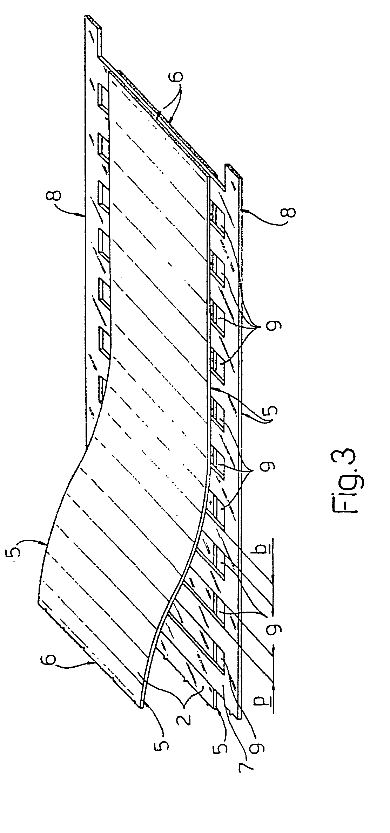

With reference to Figure 2, a composite sheet 1 of determined length is first of all prepared, which includes two substantially rectangular sheets 2 made from a material A (A=Nb or V or their alloys) and having a thickness $T_A$, which "sandwich" between them a plurality of substantially rectangular strips 4 made from a material B (B=Al, Si, Sn, Ge, Ga or their alloys) and having a thickness $t_B$ and a transverse width $b$. The sheets 2 are in the form of strips delimited by opposite major sides 5 and opposite minor sides 6. The strips have a length substantially equal to the width of the sides 6 of the sheets 2, are positioned side by side and parallel to one another and disposed transversely with respect to the sides 5, and are spaced with a predetermined separation $p$. The strips 4 can be deposited and fixed onto a face 3 of one of the sheets 2 facing the other sheet 2 by means of any known surface deposition method such as, for example, electro-deposition, electrophoresis, plasma spray, ionic implantation, evaporation under vacuum, plating or cathodic spraying (sputtering). In a preferred embodiment of the present invention the strips 4 are mechanically inserted between the sheets 2 by means of the operation illustrated in Figure 3; with reference to Figure 3, between the sheets 2 of material A is interposed a substantially rectangular sheet 7 made from the material B and of thickness $t_B$, having a width greater than that of the sheet 2 and the same length. The sheet 7 is provided, transversely of its longer sides 8, parallel to the sides 5, with a plurality of substantially rectangular windows 9 formed through it by stamping in regular succession, positioned parallel to one another and spaced from one another with a predetermined constant separation; the windows 9 have a length greater than the width 6 of the sheets 2, a width equal to $p$ and are spaced with a separation equal to $b$; in this way it is sufficient to cut the edges of the sheet 7 projecting from the sheets 2 in correspondence with the sides 5 to obtain the composite three layer sheet A/B/A indicated with the reference numeral 1 in Figure 2. In fact, the portions of the sheet 7 delimited by the windows 9, in this way constitute the strips 4 of the composite sheet 1 and remain separated from one another.

After having obtained the A/B/A composite 1 with the method described above and illustrated in Figure 3, or else with any other method such as those previously discussed, it is connected by the face of one of the sheets 2 to a sheet of copper 15 of the same length and width and of thickness $t_{Cu}$.

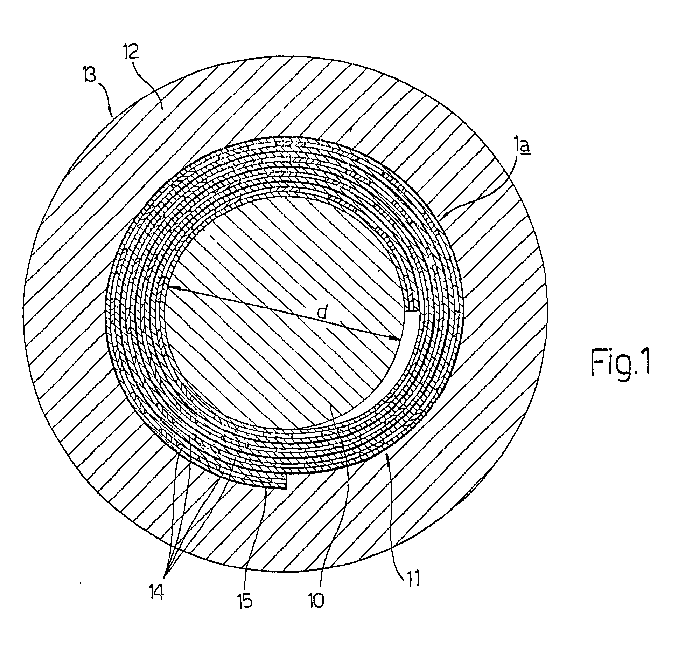

The A/B/A/Cu mutli-layer sheet 1a thus obtained (Figure 1) is wound tightly, substantially without any play, around a cylindrical copper element 10 in such a way as to form a coil 11. This winding is performed starting from the sheet 2 of material A left free from the sheet 15, in such a way as to position the sheet 2 of material A in contact with the surface of the element 10. Subsequently the coil 11 thus obtained is mounted within the interior of a substantially cylindrical container 12 of copper, preferably constituted by an open ended sleeve, into which the coil 11 is inserted coaxially, substantially without any radial play. There is thus obtained a blank 13, illustrated in Figure 1, which is composed of a plurality of parallel strips 4 disposed in several concentric rings, each ring of strips 4 being enclosed in an annular matrix of material A constituted by the spirally wound sheets 2, and the strips 4 being separated by spaces 14 of a width equal to the separation $p$; the matrix constituted by the sheets 2 is in turn enclosed in an annular matrix of copper constituted by the spirally wound sheet 15 the whole being contained in a further copper matrix constituted by the cylindrical element 10 and by the annular container 12 within which the coil 11 is enclosed.

The blank 13 is at this point worked by plastic deformation in a known way, for example by drawing, until there is obtained from it, by reduction of the transverse section and consequent elongation, a conductor (not illustrated) having the desired dimensions which will obviously have transverse dimensions less than those of the blank 13 and a length greater than that of the blank. Supposing that the final diameter of the element 10, after the plastic deformation, is $d_1$, the transverse reduction undergone by the blank 13 will be $R=d/d_1$, a non-dimensional ratio which is unvaried even taking into consideration, rather than the diameter $d$ of the element 10, the diameter $D$ of the element 12; in these conditions, with simple geometric considerations, it is obtained that the new transverse dimensions of the strips 4, which constitute the filaments of the conductor, will be $b/R$ and $t_B/R$. The conductor obtained by plastic working of the blank 13 is then twisted in a known way, with a pitch of predetermined value, sufficient to dispose the filaments constituted by the strips 4 in such a way as to guarantee the magnetic de-coupling between them, and is then subjected to one or more heat treatments in a known manner, performed in a vacuum or an inert gas atmosphere at a temperature lying in a range of values such as to avoid the formation of liquid phase, and in particular the fusion of the material B (which could cause the formation of a continuous layer of B by liquid diffusion between the strips 4), but sufficient to cause an interdiffusion between the materials A and B of the sheets 2 and the strips 4, which as is known occurs predominately in a radial sense, so as to obtain the formation of the intermetallic compound of the formula $A_3B$.

If the heat treatment is performed in the correct manner the strips 4 of material B all transform integrally into superconductor filaments of material $A_3B$. Because of the plastic deformation to which the composite 13 is subjected the cavities 14 are further filled with material A of the deformed sheets 2 and therefore, at the end of the operations described, there is obtained a superconductor in which a plurality of A-15 filaments of material $A_3B$ of substantially rectangular cross section and disposed in a ring on a series of substantially concentric rings is embedded in a series of substantially annular matrices of material A, which are in their turn embedded in substantially annular matrices of copper which, together with the further matrices of copper constituting the core and the outer ring of the conductors (elements 10 and 12) allows an excellent stabilisation of the superconducting filaments. The matrix of material A, in which these latter are embedded, further allows, as is known, a minimisation in the losses in the conductors due to possible variable components in the magnetic field and/or in the current, in that it behaves as a resistive barrier between the superconductor filaments. This resistive barrier can be improved and increased by adding to the material A an element, such as tantalum (Ta) which increases the electrical resistivity of it without detracting from the superconductor properties of the compound $A_3B$.

By means of the process described there is therefore obtained a "cable" constituted by a single intrinsically multifilamentary superconducting conductor, in which the plurality of superconductor filaments are derived not from an assembly operation of previously prepared monofilaments, but from the peculiar internal structure of the blank 13 and, in particular, of the coil 11. This allows one operation (that of assembly of the monofilaments) to be eliminated, which operation is laborious, of high cost and is difficult to automate, and provides a process in which all the phases can be easily and economically automated, involving only operations which can be effected easily.

The invention will now be illustrated with a particular example, relating to the manufacture of a superconducting cable of $Nb_3Al$ (A=Nb; B=Al).

The starting materials were constituted by a sheet of copper of 100 µm in thickness, by two sheets of niobium of 100 µm in thickness and a sheet of aluminium of a thickness of 20 µm; on this latter were formed a regular succession of windows 9 where $b$=4 mm, $p$=1 mm. After having inserted the sheet of Al between the two sheets of Nb the triple sheet Nb/Al/Nb was coupled to a sheet of Cu and the assembly wound on a copper cylinder of diameter equal to 6 mm. The coil obtained, having a diameter of 29 mm, was inserted into a cylindrical container of copper having a diameter of 40 mm. The thus obtained composite was worked plastically by drawing to obtain a wire having a diameter of 0.4 mm, which was twisted with a pitch of 2 cm. The wire was then treated under vacuum at 600°C for 24 hours and subsequently at 850°C for two hours. X-ray tests confirmed the presence of the phase $Nb_3Al$, whilst a scanning electron microscope detected that the superconductor filaments were formed with a good separation from one another in a matrix of non-reacted noibium.

A short sample of the multifilamentary superconductor thus formed was subjected to superconductivity tests; the critical temperature was nearly 16°K, whilst the current density, critical at 6 Tesla, 4.2° K, was equal to $2 \cdot 10^5$ A/cm$^2$.

**Claims**

1. A process for obtaining multifilamentary superconductors of the A-15 type, comprising a plurality of filaments of a superconductor material of the general chemical formula $A_3B$ embedded in a matrix of copper, comprising:
— preparation of a composite sheet (1) which can be wound in a spiral and comprising two sheets (2) of material A with a plurality of strips (4) of material B sandwiched between them, the strips being located alongside one another, spaced with a predetermined separation and extending transversely between the longer sides (5) of the sheets (2);
— connecting the said composite sheet (1) to a sheet (15) of copper to obtain an A/B/A/Cu multi-layer sheet (1a);
— preparation of a coil (11) by winding the said A/B/A/Cu multi-layer sheet (1a) around a cylindrical copper element (10) with the surface of this latter being located in contact with a sheet (2) of material A:
— mounting the said coil (11) within a copper container (12) in such a way as to obtain a blank (13), and working the blank (13) by plastic deformation thereof to obtain a conductor of predetermined dimensions and having transverse dimensions less than those of the blank (13) and a length greater than the blank;
— twisting the said conductor with a predetermined pitch;
— heat treatment of the said conductor in an inert environment at a temperature lying in a range of values such as to avoid the formation of liquid phase but sufficient to cause an interdiffusion between the materials A and B to obtain the compound $A_3B$.

2. A process according to Claim 1, characterised by the fact that the said heat treatment takes place under vacuum.

3. A process according to Claim 1, characterised by the fact that the said heat treatment takes place in an inert gas atmosphere.

4. A process according to any of the preceding Claims, characterised by the fact that the material A is niobium, vanadium or alloys of niobium and vanadium, and by the fact that the material B is aluminium, tin, germanium, gallium, silicon or alloys containing at least one of the said elements.

5. A process according to any preceding Claim, characterised by the fact that the said strips (4) of material B are obtained by a surface deposition process effected directly onto one face (3) of one of the said two sheets (2) of material A.

6. A process according to any of Claims from 1 to 4, characterised by the fact that the said strips (4) of material B are obtained by inserting a sheet (7) of material B between the said sheets (2) of material A to form a sandwich, there having been formed in the sheet (7) of material B a plurality of substantially rectangular windows (9) transversely disposed with respect to the longer sides (8) of the said sheet (7) and with predetermined regular separation, the width of the said sheet (7) being greater than that of the sheets (2) of material A, and cutting off the edges of the said sheet (7) projecting from the said sheets (2) of material A.

7. Multifilamentary superconductor of the A-15 type comprising a plurality of filaments of superconductor material of the formula $A_3B$ stabilised with copper, where A=Nb, V or their alloys and B=Si, Sn, Al, Ge, Ga or their alloys, characterised by the fact that the said filaments are of substantially rectangular cross section and are disposed in substantially concentric rings disposed within respective substantially annular matrices of material A in which the said filaments are embedded and which are in their turn embedded in respective first substantially annular matrices of copper, the said matrices of material A being able to serve as a resistive barrier between the said superconductor filaments, the whole being contained in a second matrix of copper constituting a core and an outer ring of the conductor.

**Patentansprüche**

1. Verfahren zur Herstellung von mehradrigen Supraleitern des A-15 Typs, bestehend aus einer Vielzahl von Adern aus supraleitendem Material der allgemeinen chemischen Formal $A_3B$, die in eine Matrix aus Kupfer eingebettet sind, beinhaltend:
— die Herstellung eines zusammengesetzten Blattes (1), das spiralig aufgewickelt werden kann, welches aus zwei Blättern (2) des Materials A mit einer Vielzahl von in Sandwich-Form Dazwischen angeordneten Streifen (4) des Materials B besteht, die Streifen längsseits nebeneinander in einem vorbestimmten Abstand zueinander liegen und sich zwischen den längeren Seiten (5) der Blätter (2) quer zu diesen Seiten erstrecken;
— die Verbindung des besagten zusammengesetzten Blatts (1) mit einem Blatt (15) aus Kupfer, um ein mehrlagiges Blatt (1a) der Form A/B/A/Cu zu erhalten;
— die Herstellung einer Rolle (11) durch Herumwickeln des besagten mehrlagigen A/B/A/Cu-Blattes (1a) um ein zylindrisches Kupferelement (10), wobei die Oberfläche des letzteren in Kontakt mit einem Blatt (2) des Materials A ist;
— das Einbringen der besagten Rolle (11) in einen Kupferbehälter (12), um so einen Rohling (13) zu erhalten und diesen durch plastische Deformation zu verarbeiten, um einen Leiter von vorbestimmten Abmessungen herzustellen, dessen Querdimensionen kleiner und dessen Länger größer als die des Rohlings sind;
— das Verdrillen des besagten Leiters mit einer vorbestimmten Ganghöhe;
— die Hitzebehandlung des besagten Leiters in einer inerten Umgebung bei einer Temperatur in einem Bereich, in dem die Ausbildung einer flüssigen Phase vermieden wird, die aber ausreicht, um eine Interdiffusion zwischen den Materialien A und B zu verursachen, um so die Verbindung $A_3B$ zu erlangen.

2. Verfahren nach Anspruch 1, dadurch gekennzeichnet, daß die besagte Hitzebehandlung in Vacuum stattfindet.

3. Verfahren nach Anspruch 1, dadurch gekennzeichnet, daß die besagte Hitzebehandlung in einer Atmosphäre von Inertgas stattfindet.

4. Verfahren nach einem der vorangehenden Ansprüche, dadurch gekennzeichnet, daß das Material A Niobium, Vanadium oder Legierungen von Niobium und Vanadium, und daß das Material B Aluminium, Zinn, Germanium, Gallium, Silizium oder Legierungen, die zumindest eines dieser Elemente enthalten, sind.

5. Verfahren nach einem der vorangenhenden Ansprüche, dadurch gekennzeichnet, daß die die besagten Streifen (4) des Materials B durch einen Oberflächenablagerungsprozeß direkt auf eine Seite (3) eines der besagten zwei Blätter (2) des Materials A erhalten werden.

6. Verfahren nach einem der Ansprüche 1 bis 4, dadurch gekennzeichnet, daß die besagten Streifen (4) des Materials B durch Einlegen eines Blattes (7) aus dem Material B zwischen die besagten zwei Blätter (2) des materials A in Sandwich-Form erfolgt, wobei in Blatt (7) des Materials B eine Vielzahl von, in wesentlichen rechteckigen, Ausschnitten (9) vorgesehen sind, die quer liegen in bezug auf die längeren Seiten (8) des besagten Blattes (7), dessen Breite größer ist als die Breite der Blätter (2) des Materials A, und daß die, über die Breite der Blätter (2) hervorstehenden Teile des besagten Blattes (7) weggeschnitten werden.

7. Mehradriger Supraleiter des A-15 Typs, enthaltend eine Vielzahl von Adern aus supraleitendem Material der allgemeinen Formel $A_3B$, stabilisiert mit Kupfer, wobei A=Nb, V oder deren Legierungen und B=Al, Sn, Ge, Ga, Si oder deren Legierungen sind, dadurch gekennzeichnet, daß die besagten Adern einen im wesentlichen rechteckigen Querschnitt aufweisen und in, im wesentlichen konzentrischen Ringen innerhalb von, im wesentlichen ringförmigen Matrizes aus dem Material A eingebetter sind und die ihrerseits in einer ersten, im wesentlichen ringförmigen Matrix aus Kupfer eingebetter sind, wobei die besagten Matrizes aus dem Material A als Widerstandsbarriere zwischen den besagten supraleitenden Adern dienen können, und die gesamte Anordnung in einer zweiten Matrix aus Kupfer enthalten ist, die aus einem Kern und einem äußeren Ring des Leiters besteht.

**Revendications**

1. Procédé pour obenir des supraconducteurs multifilaires du type A-15, comprenant une multiplicité de filaments d'un matériau supraconducteur de la formule chimique générale $A_3B$, noyés

dans une matrice de cuivre, comprenant les phases suivantes:

— préparer une feuille composite (1) qui peut être enroulée en spirale et comprend deux feuilles (2) d'un matériau A avec une multiplicité de bandes (4) d'un matériau B prises en sandwich entre elles, les bandes étant disposées parallèlement les unes aux autres, espacées d'une distance prédéterminée et s'étendant transversalement entre les grands côtés (5) des feuilles (2);

— relier la feuille composite (1) à une feuille (15) de cuivre, pour obtenir une feuille multicouches A/B/A/Cu (1a);

— préparer une bobine (11) en enroulant ladite feuille multi-couches A/B/A/Cu (1a) autour d'un élément cylindrique en cuivre (10) avec la surface de ce dernier en contact avec une feuille (2) de matériau A;

— monter cette bobine (11) à l'intérieur d'un récipient de cuivre (12) de façon à obtenir une ébauche (13) et travailler l'ébauche (13) par déformation plastique pour obtenir un conducteur de dimensions prédéterminées ayant des dimensions transversales inférieures à cells de l'ébuche (13) et une longueur supérieure à celle de l'ébauche;

— tordre ledit conducteur à un pas prédéterminé;

— effectuer un traitement thermique de ce conducteur dans un environnement inerte à une température située dans une plage de valeurs telles que l'on évite la formation d'une phase liquide, mais suffisante pour provoquer une interdiffusion entre les matériaux A et B pour obtenir le composé $A_3B$.

2. Procédé selon la revendication 1, caractérisé en ce que ce traitement thermique s'effectue sous vide.

3. Procédé selon la revendication 1, caractérisé en ce que ce traitement thermique s'effectue dans une atmosphère de gaz inerte.

4. Procédé selon l'une quelconque des revendications précédentes, caractérisé en ce que le matériau A est le niobium, le vanadium ou des alliages de niobium et de vanadium, et en ce que le matériau B est l'aluminium, l'étain, le germanium, le gallium, le silicium, ou des alliages contenant au moins l'un de ces éléments.

5. Procédé selon l'une quelconque des revendications précédentes, caractérisé en ce que les bandes (4) de matériau B sont obtenues par un procédé de dépôt surfacique effectué directement sur une face (3) de l'une des deux feuilles (2) de matériau A.

6. Procédé selon l'une quelconque des revendications 1 à 4, caractérisé en ce que les bandes (4) de matériau B sont obtenues en introduisant une feuille (7) de matériau B entre les feuilles (2) de matériau A pour former un sandwich, une multiplicité de fenêtres sensiblement rectangulaires (9) disposées transversalement par rapport aux grands côtés (8) de la feuille (7) et séparées les unes des autres d'une distance constante prédéterminée étant formée dans la feuille (7) de matériau B, la largeur de la feuille (7) étant supérieure à celle des feuilles (2) de matériau A, et en ce qu'on coupe les bords de la feuille (7) dépassant des feuilles (2) de matériau A.

7. Supraconducteur multifilaire du type A-15 comprenant une multiplicité de filaments de matériau supraconducteur de la formule $A_3B$ stabilisé par du cuivre, dans laquelle A=Nb, V ou leurs alliages et B=Si, Sn, Al, Ge, Ga ou leurs alliages, caractérisé en ce que les filaments ont une section transversale sensiblement rectangulaire et sont disposés en couronnes sensiblement concentriques disposées à l'intérieur de matrices respectives sensiblement annulaires de matériau A dans lesquelles sont noyés ces filaments et qui sont à leur tour noyées dans des premières matrices respectives sensiblement annulaires de cuivre, ces matrices de matériau A étant susceptibles de servir de barrière résistance entre les filaments supraconducteurs, le tout étant contenu dans une deuxième matrice de cuivre constituant un noyau central et une couronne extérieure du conducteur.

Fig.1

Fig.2

Fig.3